(19) Europäisches Patentamt
European Patent Office
Office européen des brevets

(11) **EP 4 163 083 B1**

(12) **EUROPÄISCHE PATENTSCHRIFT**

(45) Veröffentlichungstag und Bekanntmachung des Hinweises auf die Patenterteilung:
**24.04.2024 Patentblatt 2024/17**

(21) Anmeldenummer: **21020496.2**

(22) Anmeldetag: **06.10.2021**

(51) Internationale Patentklassifikation (IPC):
*B29C 64/135* (2017.01)      *B29C 64/268* (2017.01)
*B29C 64/273* (2017.01)      *B29C 64/286* (2017.01)
*B33Y 10/00* (2015.01)      *B33Y 30/00* (2015.01)
*B29C 64/264* (2017.01)      *G03F 7/20* (2006.01)

(52) Gemeinsame Patentklassifikation (CPC):
**G03F 7/70416;** B29C 64/268; **B29C 64/135;**
**B29C 64/264; B29C 64/273; B29C 64/286;**
**B33Y 10/00; B33Y 30/00;** B29C 64/393

(54) **VERFAHREN UND VORRICHTUNG ZUR LITHOGRAPHIEBASIERTEN GENERATIVEN FERTIGUNG EINES DREIDIMENSIONALEN BAUTEILS**

METHOD AND DEVICE FOR LITHOGRAPHY-BASED GENERATIVE PRODUCTION OF A THREE-DIMENSIONAL COMPONENT

PROCÉDÉ ET DISPOSITIF DE FABRICATION ADDITIVE PAR LITHOGRAPHIE D'UN COMPOSANT TRIDIMENSIONNEL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**12.04.2023 Patentblatt 2023/15**

(73) Patentinhaber: **UpNano GmbH**
**1030 Wien (AT)**

(72) Erfinder: **Gruber, Peter**
**A-1140 Wien (AT)**

(74) Vertreter: **Keschmann, Marc**
**Haffner und Keschmann Patentanwälte GmbH**
**Schottengasse 3a**
**1010 Wien (AT)**

(56) Entgegenhaltungen:
EP-A1- 3 671 344      WO-A1-2015/197794
WO-A1-2018/206161      CN-A- 112 034 628
CN-A- 112 859 538      CN-A- 113 189 847
JP-A- H0 999 490      US-B2- 6 999 158

**Beschreibung**

Die Erfindung betrifft ein Verfahren zur lithographiebasierten generativen Fertigung eines dreidimensionalen Bauteils, bei dem ein von einer elektromagnetischen Strahlungsquelle ausgesendeter Strahl mittels einer optischen Abbildungseinheit auf einen Fokuspunkt innerhalb eines Materials fokussiert wird und der Fokuspunkt mittels einer der optischen Abbildungseinheit in Strahlrichtung vorgeordneten Ablenkeinheit verlagert wird, wodurch nacheinander jeweils ein am Fokuspunkt befindliches Volumenelement des Materials mittels Multiphotonenabsorption verfestigt wird.

Die Erfindung betrifft weiters eine Vorrichtung zur lithographiebasierten generativen Fertigung eines dreidimensionalen Bauteils.

Ein Verfahren zur Ausbildung eines Bauteils, bei dem die Verfestigung eines photosensitiven Materials mittels Multiphotonenabsorption vorgenommen wird, ist beispielsweise aus der DE 10111422 A1 bekannt geworden. Dazu strahlt man mit einem fokussierten Laserstrahl in das Bad des photosensitiven Materials ein, wobei die Bestrahlungsbedingungen für einen die Verfestigung auslösenden Mehrphotonenabsorptionsprozess nur in unmittelbarer Umgebung des Fokus erfüllt sind, sodass man den Fokus des Strahls nach Maßgabe der Geometriedaten des herzustellenden Formkörpers innerhalb des Badvolumens zu den zu verfestigenden Stellen führt. WO 2015/197794 A1 offenbart ein Verfahren zur lithographiebasierten generativen Fertigung eines dreidimensionalen Bauteils, bei dem ein von einer elektromagnetischen Strahlungsquelle ausgesendeter Strahl mittels einer optischen Abbildungseinheit auf einen Fokuspunkt innerhalb eines Materials fokussiert wird.

Am jeweiligen Fokuspunkt wird hierbei ein Volumenelement des Materials verfestigt, wobei benachbarte Volumenelemente aneinanderhaften und das Bauteil durch nacheinander erfolgendes Verfestigen von benachbarten Volumenelementen aufgebaut wird. Beim Aufbau des Bauteils kann man schichtweise vorgehen, d.h. es werden zuerst Volumenelemente einer ersten Schicht verfestigt, bevor Volumenelemente einer nächsten Schicht verfestigt werden.

Bestrahlungseinrichtungen für Multiphotonen-Absorptionsverfahren umfassen eine Optik zum Fokussieren eines Laserstrahls sowie eine Ablenkeinrichtung zum Ablenken des Laserstrahls. Die Ablenkeinrichtung ist hierbei ausgebildet, um den Strahl nacheinander auf Fokuspunkte innerhalb des Materials zu fokussieren, die in ein und derselben, vorzugsweise senkrecht zur Einstrahlrichtung des Strahls in das Material verlaufenden Ebene liegen. In einem x,y,z-Koordinatensystem wird diese Ebene auch als x,y-Ebene bezeichnet. Die durch die Strahlablenkung in der x,y-Ebene entstandenen verfestigten Volumenelemente bilden eine Schicht des Bauteils aus.

Für den Aufbau einer nächsten Schicht erfolgt eine Veränderung der Relativposition der Fokussieroptik relativ zum Bauteil in der z-Richtung, welche einer Einstrahlrichtung des wenigstens einen Strahls in das Material entspricht und senkrecht zur x,y-Ebene verläuft. Durch die zumeist motorisch erfolgende Verstellung der Fokussieroptik relativ zum Bauteil wird der Fokuspunkt in eine neue x,y-Ebene verlagert, welche in z-Richtung um die gewünschte Schichtdicke von der vorangehenden x,y-Ebene beabstandet ist.

Die Strukturierung eines geeigneten Materials mittels Multiphotonenabsorption bietet den Vorteil einer überaus hohen Strukturauflösung, wobei Volumenelemente mit minimalen Strukturgrößen von bis zu 50nm x 50nm x 50nm erzielbar sind. Bedingt durch das kleine Fokuspunktvolumen ist der Durchsatz eines solchen Verfahrens allerdings sehr gering, da z.B. für ein Volumen von Imm$^3$ insgesamt mehr als $10^9$ Punkte belichtet werden müssen. Dies führt zu sehr langen Bauzeiten, was der Hauptgrund für den geringen industriellen Einsatz von MultiphotonenabsorptionsVerfahren ist.

Um den Bauteiledurchsatz zu erhöhen ohne die Möglichkeit einer hohen Strukturauflösung zu verlieren, wurde bereits vorgeschlagen, das Volumen des Fokuspunkts während des Aufbaus des Bauteils zumindest einmal zu variieren, sodass das Bauteil aus verfestigten Volumenelementen unterschiedlichen Volumens aufgebaut wird. Durch das variable Volumen des Fokuspunktes sind (bei kleinem Fokuspunktvolumen) hohe Auflösungen möglich. Gleichzeitig ist (bei großem Fokuspunktvolumen) eine hohe Schreibgeschwindigkeit (gemessen in mm$^3$/h) erzielbar. Durch das Variieren des Fokuspunktvolumens kann also eine hohe Auflösung mit großem Durchsatz kombiniert werden. Die Variation des Fokuspunktvolumens kann dabei zum Beispiel so genutzt werden, dass im Inneren des aufzubauenden Bauteils ein großes Fokuspunktvolumen verwendet wird, um den Durchsatz zu erhöhen, und an der Oberfläche des Bauteils ein kleineres Fokuspunktvolumen zur Anwendung kommt, um die Bauteiloberfläche mit hoher Auflösung auszubilden. Eine Vergrößerung des Fokuspunktvolumens ermöglicht einen höheren Strukturierungsdurchsatz, da das in einem Belichtungsvorgang verfestigte Materialvolumen vergrößert wird. Um bei hohem Durchsatz eine hohe Auflösung beizubehalten, können kleine Fokuspunktvolumina für feinere Strukturen und Oberflächen, und größere Fokuspunktvolumina für grobe Strukturen und/oder zum Füllen von Innenräumen verwendet werden. Verfahren und Vorrichtungen zur Veränderung des Fokuspunktvolumens sind in der WO 2018/006108 A1 beschrieben.

Die Erfindung zielt darauf ab, ein Verfahren und eine Vorrichtung zur lithographiebasierten generativen Fertigung eines dreidimensionalen Bauteils dahingehend weiterzuentwickeln, dass die Schreibgeschwindigkeit (gemessen in mm$^3$/h) noch weiter erhöht wird.

Zur Lösung dieser Aufgabe sieht die Erfindung bei einem Verfahren der eingangs genannten Art vor, dass der Strahl mit einem Strahlteiler auf eine Mehrzahl von Strahlen aufgeteilt wird, von denen jeder mittels der Ablenkeinheit und der optischen Abbildungseinheit nacheinander auf Fokuspunkte innerhalb des Materials fokussiert wird, wobei eine der Anzahl der Strahlen entsprechende Anzahl von akustooptischen Modulatormodulen vorgesehen wird, sodass im Strahlengang jedes Strahls ein akustooptisches Modulatormodul angeordnet ist, welches den Strahl beugt.

Durch die Erfindung wird somit ein paralleles Schreiben mit einer Mehrzahl von Strahlen ermöglicht, sodass die Schreibgeschwindigkeit um die Anzahl der Strahlen entsprechend vervielfacht wird. Der Strahlteiler ist hierbei ausgebildet, um den Strahl auf wenigstens zwei Strahlen aufzuteilen. Bevorzugt ist der Strahlteiler ausgebildet, um den Strahl auf 2, 4, 8, 16, 32 oder 64 Strahlen aufzuteilen. Es ist auch jede beliebige andere Anzahl von Strahlen möglich, wie z.B. eine ungerade Zahl von Strahlen.

Dadurch, dass im Strahlengang jedes Strahls ein akustooptisches Modulatormodul angeordnet ist, kann jeder Strahl unabhängig von den anderen Strahlen beeinflusst werden, und zwar bevorzugt dahingehend, dass die Position des Fokuspunkts des jeweiligen Strahls unabhängig von den Fokuspunkten der anderen Strahlen verstellt werden kann oder dass die Strahlungsintensität des jeweiligen Strahls unabhängig von den Fokuspunkten der anderen Strahlen verstellt werden kann.

Je nach Konfiguration der akustooptischen Modulatormodule kann der Fokuspunkt in beliebige Raumrichtungen verstellt werden. Bevorzugt ist hierbei vorgesehen, dass wenigstens eines der akustooptischen Modulatormodule angesteuert wird, um den Fokuspunkt des zugehörigen Strahls in einer z-Richtung zu verlagern, wobei die z-Richtung einer Einstrahlrichtung des jeweiligen Strahls in das Material entspricht.

Alternativ oder zusätzlich kann wenigstens eines der akustooptischen Modulatormodule angesteuert werden, um den Fokuspunkt des zugehörigen Strahls in einer x- und/oder y-Richtung zu verlagern, wobei die x- und y-Richtung zwei orthogonalen Richtungen in einer zur Einstrahlrichtung des jeweiligen Strahls senkrechten Ebene entsprechen.

Durch die Anordnung wenigstens eines akustooptischen Modulators im Strahlengang jedes Strahls kann jeder Fokuspunkt stufenlos und mit hoher Geschwindigkeit in x-, y- und/oder z-Richtung verlagert werden. Dies erlaubt es, die Position eines Volumenelements frei zu wählen und Volumenelemente daher auch außerhalb der durch die Schichtebene definierten z-Positionen anzuordnen, um auf diese Weise eine optimale Anpassung an die jeweils zu erzielende Oberflächenform zu erreichen. Die Verlagerung des Fokuspunkts in x-, y- und/oder z-Richtung erfordert hierbei keine mechanische Verstellung der optischen Abbildungseinheit relativ zum Bauteil und ist daher unabhängig vom Wechsel von einer ersten zu einer nächsten Schicht. Insbesondere gelingt die Verlagerung des Fokuspunkts ohne bewegliche Teile, sondern alleine auf Grund der Wirkung des erwähnten akustooptischen Modulatormoduls.

Ein akustooptischer Modulator ist ein optisches Bauelement, das einfallendes Licht in Frequenz und Ausbreitungsrichtung oder Intensität beeinflusst. Hierzu wird in einem transparenten Festkörper mit Schallwellen ein optisches Gitter erzeugt, an dem der Lichtstrahl gebeugt wird. Dies kann bei Ausbildungen, die als akustooptischer Deflektor bezeichnet werden, dazu genutzt werden, um eine Strahlablenkung zu erzeugen, wobei der Ablenkungswinkel von den relativen Wellenlängen von Licht- und Schallwellen im transparenten Festkörper abhängt. Durch eine Änderung der Schallwellenfrequenz kann hierbei der Ablenkungswinkel eingestellt werden. Dies kann für die oben beschriebene Feinverstellung des Fokuspunkts in x- und/oder y-Richtung verwendet werden.

Die Verlagerung in der z-Richtung erfolgt beispielsweise dadurch, dass in dem akustooptischen Deflektor eine Schallwelle erzeugt wird, deren Frequenz periodisch moduliert wird. Durch eine periodische Variation der Frequenz der im transparenten Festkörper erzeugten Schallwelle bildet sich bei einem akustooptischen Deflektor ein sogenannter "Zylinderlinseneffekt" aus, welcher den einfallenden Lichtstrahl in gleicher Weise bündelt wie eine Zylinderlinse. Eine gezielte Steuerung der periodischen Frequenzmodulation erlaubt es, die Brennweite der Zylinderlinse und damit die Divergenz des aus dem akustooptischen Deflektor austretenden Strahls zu verändern. Der Strahl mit der solcherart eingestellten Divergenz wird durch eine Abbildungseinheit der Bestrahlungseinrichtung geleitet, in welcher der Strahl mittels eines Objektivs fokussiert in das Material eingestrahlt wird. Der Fokuspunkt des in das Material eingebrachten Strahls variiert hierbei in z-Richtung in Abhängigkeit von der Divergenz.

Eine bevorzugte Ausbildung sieht hierbei vor, dass die Frequenzmodulation der Schallwelle einen konstanten Schallwellenfrequenzgradienten aufweist. Dies begünstigt die Entstehung des sogenannten "Zylinderlinseneffekts".

Bevorzugt ist weiters vorgesehen, dass der Fokuspunkt durch eine Änderung des (konstanten) Schallwellenfrequenzgradienten der Frequenzmodulation verlagert wird. Die Änderung des Schallwellenfrequenzgradienten kann beispielswiese durch eine Änderung der Bandbreite der Frequenzmodulation bei gleichbleibender Periodendauer der periodischen Modulation erreicht werden. Alternativ kann die Bandbreite konstant gehalten und die Änderung des Schallwellenfrequenzgradienten durch eine Veränderung der Periodendauer bewirkt werden.

Die Grundfrequenz der Schallwelle beträgt bei einem transparenten Festkörper aus z.B. $TeO_2$ bevorzugt 50 MHz oder mehr, insbesondere > 100 MHz, insbesondere 100-150 MHz. Die Grundfrequenz wird beispielsweise um mindestens ± 10 %, bevorzugt ± 20-30 %, moduliert. Im Falle einer Grundfrequenz von z.B. 110 MHz wird diese beispielsweise um ±25 MHz periodisch moduliert, d.h. die Bandbreite der Frequenzmodulation beträgt 50 MHz und die Frequenz der Schallwelle wird daher zwischen 85 MHz und 135 MHz periodisch moduliert. Wie bereits erwähnt, bestimmt die Änderung des Schallwellenfrequenzgradienten die Brennweite der Zylinderlinse, wobei die Modulationsfrequenz bevorzugt mindesten 100 kHz, insbesondere 0.1-10 MHz beträgt.

Weiters kann ein akustooptisches Modulatormodul auch verwendet werden, um die Intensität des in das Material eingebrachten Strahls zu verändern. Die Veränderung kann auch eine Reduzierung der Strahlungsintensität auf Null umfassen, sodass die aus dem Strahlteiler kommenden Strahlen je nach Bedarf einzeln ein- und ausgeschaltet werden können. Für die Einstellung der Strahlungsintensität wird die Amplitude der in den akustooptischen Modulator eingebrachten Schallwelle verändert.

Ein akustooptischen Modulatormodul umfasst zumindest einen akustooptischen Modulator, wie z.B. einen, zwei oder vier akustooptische Modulatoren. Im Fall von mindestens zwei akustooptischen Modulatoren kann jeder Modulator als eigenes Bauteil ausgebildet sein, die hintereinander von dem jeweiligen Strahl durchstrahlt werden. Alternativ können wenigstens zwei akustooptischen Modulatoren funktional in einem einzigen Modulatorbauteil zusammengefasst werden (sog. Multichannel-Ausführung), der für jeden Kanal einen Kristall mit entsprechender Schalleinleitung aufweist.

Vorzugsweise werden in den akustooptischen Modulatormodulen jeweils wenigstens zwei im Strahlengang hintereinander angeordnete akustooptische Modulatoren verwendet, wobei die wenigstens zwei akustooptischen Modulatoren bevorzugt eine im Wesentlichen senkrecht zueinander verlaufende Richtung der Strahlablenkung oder eine gleiche Orientierung der Strahlablenkung aufweisen. Die Kombination von zwei bevorzugt unmittelbar hintereinander, senkrecht zueinander angeordneten akustooptischen Modulatoren behebt den bei einem einzigen Modulator sonst auftretenden Astigmatismus. Bei einer Anordnung von zwei akustooptischen Modulatoren in einer Ebene wird der mögliche Verstellweg des Fokuspunkts in x- und y-Richtung verdoppelt. Gemäß einer weitere bevorzugten Ausführung können vier hintereinander angeordnete akustooptische Modulatoren vorgesehen sein, von denen die ersten beiden Modulatoren ein erstes Paar und die nachfolgenden beiden Modulatoren ein zweites Paar bilden. Die Modulatoren innerhalb eines Paars sind hierbei jeweils mit gleicher Orientierung der Strahlablenkung ausgebildet und die Modulatoren des ersten Paars weisen eine bezüglich der Modulatoren des zweiten Paars senkrecht verlaufende Richtung der Strahlablenkung auf.

Während die Verlagerung der Fokuspunkte durch die akustooptischen Modulatormodule der Feinpositionierung der Fokuspunkte dienen, um Volumenelemente z.B. außerhalb der üblichen Rasterpunkte zu verfestigen (sog. "grayscale lithography"), werden die Schreibstrahlen mittels einer von den akustooptischen Modulatormodulen gesonderten Ablenkeinheit in x- und y-Richtung durch den gesamten Schreibbereich bewegt. Eine bevorzugte Ausbildung sieht in diesem Zusammenhang vor, dass die Strahlen mittels der den akustooptischen Modulatormodulen im Strahlengang nachgeordneten Ablenkeinheit, insbesondere einem Galvanometerscanner, einer gemeinsamen Auslenkung in der x- und y-Richtung unterworfen werden. Die Ablenkeinheit ist hierbei mit Vorteil im Strahlengang zwischen den akustooptischen Modulatormodulen und der optischen Abbildungseinheit angeordnet. Zur zweidimensionalen Strahlablenkung kann entweder ein Spiegel in zwei Richtungen ausgelenkt werden oder es werden zwei orthogonal drehbare stehende Spiegel nahe beieinander aufgestellt, über die der Strahl reflektiert wird. Weiters ist es möglich ein Linsensystem, insbesondere eine 4f-Anordnung, zwischen den Spiegel anzuordnen, sodass die Drehachse des ersten Spiegel auf den zweiten Spiegel projiziert wird, wodurch geometrische Abbildungsfehler vermieden werden. Die beiden Spiegel können von je einem Galvanometerantrieb oder Elektromotor angetrieben werden. Wesentlich ist jedenfalls, dass alle Strahlen, die vom Strahlungsteiler erzeugt werden und danach je ein akustooptisches Modulatormodul durchlaufen, mit Hilfe ein- und derselben Ablenkeinheit abgelenkt und danach mit ein- und derselben optischen Abbildungseinheit in das Material fokussiert werden.

Bevorzugt wird das Bauteil schichtweise mit sich in der x-y-Ebene erstreckenden Schichten aufgebaut, wobei der Wechsel von einer Schicht zu einer nächsten Schicht die Veränderung der Relativposition der optischen Abbildungseinheit relativ zum Bauteil in der z-Richtung umfasst. Durch die mechanische Verstellung der Relativposition der optischen Abbildungseinheit relativ zum Bauteil erfolgt die Grobverstellung der Fokuspunkte in der z-Richtung, nämlich der Wechsel von einer zur nächsten Schicht. Für die Einstellung von Zwischenstufen in der z-Richtung, d.h. für die Feinpositionierung des Fokuspunkts in z-Richtung, werden die Fokuspunkte hingegen mittels der erwähnten akustooptischen Modulatormodule positionsverändert.

Bevorzugt kann hierbei so vorgegangen werden, dass die Verlagerung des Fokuspunkts in z-Richtung mittels der akustooptischen Modulatormodule innerhalb der Schichtdicke einer Schicht erfolgt. Dabei können innerhalb einer Schicht auch mehrere in z-Richtung übereinander angeordnete Lagen von Volumenelementen hergestellt werden ohne dass eine mechanische Verstellung der Relativposition der optischen Abbildungseinheit relativ zum Bauteil erfolgen muss.

Gemäß einer bevorzugten Anwendung der Erfindung wird zumindest einer der Fokuspunkte mittels der akustooptischen Modulatormodule in z-Richtung verlagert, um eine gekrümmte Außenkontur des Bauteils auszubilden. Alternativ oder ergänzend kann auch so vorgegangen werden, dass zumindest einer der Fokuspunkte mittels des akustooptischen Modulatormoduls in z-Richtung verlagert wird, um eine relativ zur x,y-Ebene schräg verlaufende Außenkontur des Bauteils auszubilden. Die Verlagerung wenigstens eines der Fokuspunkte in z-Richtung kann hierbei der Oberflächenform folgen, indem der Fokuspunkt im Randbereich des Bauteils jeweils in einem solchen Abstand von der Oberfläche des herzustellenden Bauteils positioniert wird, der dem Abstand des gedachten Mittelpunkts des zu verfestigenden Volumenelements zur Außenfläche des Volumenelements entspricht.

Eine bevorzugte Verfahrensweise ergibt sich, wenn das Material auf einem Materialträger, wie z.B. in einer Wanne, vorliegt, und die Bestrahlung des Materials von unten durch den für die Strahlung zumindest bereichsweise durchlässigen Materialträger erfolgt. Hierbei kann eine Bauplattform in Abstand vom Materialträger positioniert und das Bauteil durch Verfestigen von zwischen der Bauplattform und dem Materialträger befindlichem Material auf der Bauplattform aufgebaut werden. Alternativ ist es aber auch möglich, die Bestrahlung des Materials von oben vorzunehmen.

Im Rahmen der vorliegenden Erfindung kann die Bauzeit erheblich verkürzt werden, wenn die im Bauteilinneren befindlichen Schichten mit hoher Schichtdicke und daher mit großvolumigen Volumenelementen aufgebaut und die Randbereiche aus kleinvolumigen Volumenelementen erstellt werden und in den Randbereichen zusätzlich eine individuelle Anpassung der Position der Volumenelemente entlang der z-Richtung erfolgt, um an der Oberfläche eine hohe Strukturauflösung zu erhalten.

Bei einer bevorzugten Verfahrensweise erfolgt die Variation des Fokusvolumens derart, dass das Volumenverhältnis zwischen dem größten Fokuspunktvolumen während der Fertigung eines Bauteils und dem kleinsten Fokuspunktvolumen mindestens 2, bevorzugt mindestens 5 beträgt. Bevorzugt ist vorgesehen, dass die Änderung des Fokuspunktvolumens in wenigstens einer, bevorzugt zwei, insbesondere in drei, senkrecht zueinander stehenden Raumrichtungen erfolgt.

Die Änderung des Fokuspunktvolumens erfolgt bevorzugt durch die Ablenkung der einzelnen Strahlen durch das zugehörige akustooptischen Modulatormodul in einer Richtung quer zur Fortbewegungsrichtung des jeweiligen Schreibstrahls, die durch die Ablenkeinheit, insbesondere den Galvanometerscanner hervorgerufen wird. Wenn der Galvanometerscanner den jeweiligen Strahl also z.B. in x-Richtung bewegt, um nacheinander in x-Richtung hintereinander liegende Volumenelemente zu verfestigen, kann das zugehörige akustooptische Modulatormodul so angesteuert werden, dass der Strahl quer dazu, z.B. in y-Richtung, mit hoher Geschwindigkeit hin- und herbewegt wird. Die Amplitude der genannten Hin- und Herbewegung bestimmt hierbei die Ausdehnung des Volumenelements. Durch Veränderung der Amplitude kann somit das Fokuspunktvolumen bzw. das Volumen des zu verfestigenden Volumenelements variiert werden. Die Hin- und Herbewegung erfolgt hierbei mit einer Geschwindigkeit, die mindestens dem 5-fachen, bevorzugt mindestens dem 10-fachen der Geschwindigkeit in Fortbewegungsrichtung des Schreibstrahls entspricht, die durch die Ablenkeinheit, insbesondere den Galvanometerscanner, in x-Richtung bewirkt wird. Es versteht sich, dass das soeben beschriebene Verfahren zur Veränderung des Volumens des zu verfestigenden Volumenelements mit umgekehrter Anordnung der x- und y-Richtung durchgeführt werden kann, sodass die Ablenkeinheit den Schreibstrahl bzw. den Fokuspunkt in y-Richtung weiterbewegt und die schnelle Hin- und Herbewegung durch das akustooptischen Modulatormodul quer dazu, z.B. in x-Richtung, erfolgt.

Das Prinzip der Multiphotonenabsorption wird im Rahmen der Erfindung genutzt, um im photosensitiven Materialbad einen photochemischen Vorgang zu initiieren. Multiphotonenabsorptionsverfahren umfassen beispielsweise auch Verfahren der 2-Photonenabsorption. Als Folge der photochemischen Reaktion kommt es zur Veränderung des Materials in mindestens einen anderen Zustand, wobei es typischerweise zu einer Photopolymerisation kommt. Das Prinzip der Multiphotonenabsorption beruht darauf, dass der genannte photochemische Vorgang nur in jenen Bereichen des Strahlengangs stattfindet, in denen eine für die Multiphotonenabsorption ausreichende Photonendichte vorliegt. Die höchste Photonendichte tritt im Brennpunkt des optischen Abbildungssystems auf, sodass die Multiphotonenabsorption mit ausreichender Wahrscheinlichkeit nur im Fokuspunkt auftritt. Außerhalb des Brennpunktes ist die Photonendichte geringer, sodass die Wahrscheinlichkeit der Multiphotonenabsorption außerhalb des Brennpunktes zu gering ist, um eine unumkehrbare Veränderung des Materials durch eine photochemische Reaktion zu bewirken. Die elektromagnetische Strahlung kann in der verwendeten Wellenlänge weitestgehend ungehindert das Material passieren und nur im Fokuspunkt kommt es zu einer Interaktion zwischen photosensitivem Material und elektromagnetischer Strahlung. Das Prinzip der Multiphotonenabsorption ist beispielsweise in Zipfel et al, "Nonlinear magic: multiphoton microscopy in the biosciences", NATURE BIOTECHNOLOGY VOLUME 21 NUMBER 11 NOVEMBER 2003, beschrieben.

Als Quelle für die elektromagnetische Strahlung kann es sich vorzugsweise um einen kollimierten Laserstrahl handeln. Der Laser kann sowohl eine oder mehrere, feste oder variable Wellenlängen emittieren. Insbesondere handelt es sich um einen kontinuierlichen oder gepulsten Laser mit Pulslängen im Nanosekunden-, Pikosekunden- oder Femtosekunden-Bereich. Ein gepulster Femtosekundenlaser bietet dabei den Vorteil, dass eine geringere mittlere Leistung für die Multiphotonenabsorption benötigt wird.

Unter photosensitivem Material wird jedes unter Baubedingungen fließfähige oder feste Material verstanden, das durch Multiphotonenabsorption im Fokuspunktvolumen in einen zweiten Zustand übergeht - beispielsweise durch Polymerisation. Die Materialveränderung muss sich dabei auf das Fokuspunktvolumen und dessen direkte Umgebung begrenzen. Die Veränderung der Substanzeigenschaften kann dauerhaft sein und beispielsweise in einer Veränderung von einem flüssigen in einen festen Zustand bestehen, kann jedoch auch nur vorübergehend sein. Auch eine dauerhafte Veränderung kann im Übrigen reversibel oder nicht reversibel sein. Die Änderung der Materialeigenschaften muss nicht zwingend vollständig von einem in den anderen Zustand übergehen, sondern kann auch als Mischform beider Zustände vorliegen.

Die Leistung der elektromagnetischen Strahlung und die Belichtungsdauer beeinflussen die Qualität des erzeugten Bauteils. Durch Anpassung der Strahlungsleistung und/oder der Belichtungsdauer kann das Volumen des Fokuspunktes in einem engen Bereich variiert werden. Bei zu hohen Strahlungsleistungen treten zusätzliche Prozesse auf, die zur Beschädigung des Bauteils führen können. Ist die Strahlungsleistung zu gering, kann sich keine dauerhafte Materialeigenschaftsänderung einstellen. Für jedes photosensitive Material gibt es daher typische Bauprozessparameter die mit guten Bauteileigenschaften verbunden sind. Im Rahmen der Erfindung wird ein Bauteil bevorzugt mit über den gesamten Bauprozess gleichbleibender Strahlungsleistung hergestellt wird.

Gemäß einem zweiten Aspekt der Erfindung wird eine Vorrichtung zur lithographiebasierten generativen Fertigung eines dreidimensionalen Bauteils, insbesondere zur Durchführung eines Verfahrens gemäß dem ersten Aspekt der Erfindung, bereitgestellt, umfassend einen Materialträger für ein verfestigbares Material und eine Bestrahlungseinrichtung, die zur ortsselektiven Bestrahlung des verfestigbaren Materials mit wenigstens einem Strahl ansteuerbar ist, dadurch gekennzeichnet, dass die Bestrahlungseinrichtung einen Strahlteiler zur Aufteilung eines Eingangsstrahls in mehrere Strahlen, eine dem Strahlteiler im Strahlengang nachgeordnete Ablenkeinheit und eine der Ablenkeinheit nachgeordnete optische Abbildungseinheit umfasst, um jeden Strahl nacheinander auf Fokuspunkte innerhalb des Materials zu fokussieren, wodurch jeweils ein am Fokuspunkt befindliches Volumenelement des Materials mittels Multiphotonenabsorption verfestigbar ist, wobei eine der Anzahl der Strahlen entsprechende Anzahl von akustooptischen Modulatormodulen vorgesehen ist, sodass im Strahlengang jedes Strahls ein akustooptisches Modulatormodul angeordnet ist, welches wenigstens einen akustooptischen Modulator umfasst.

Bevorzugt sind die akustooptischen Modulatormodule zur Verlagerung des jeweiligen Fokuspunkts in einer z-Richtung ausgebildet, wobei die z-Richtung einer Einstrahlrichtung des zugehörigen Strahls in das Material entspricht.

Bevorzugt umfasst die Steuerung des wenigstens einen akustooptischen Modulatormoduls einen Frequenzgenerator, der zur periodischen Modulation der Schallwellenfrequenz ausgebildet ist.

Bevorzugt ist hierbei vorgesehen, dass der Frequenzgenerator ausgebildet ist, um den Schallwellenfrequenzgradienten zu verändern.

Bevorzugt ist weiters vorgesehen, dass die akustooptischen Modulatormodule zur Verlagerung des jeweiligen Fokuspunkts in einer x- und/oder y-Richtung ausgebildet sind, wobei die x- und y-Richtung zwei orthogonalen Richtungen in einer zur Einstrahlrichtung des jeweiligen Strahls senkrechten Ebene entsprechen.

Wie bereits im Zusammenhang mit dem erfindungsgemäßen Verfahren erwähnt, ist es vorteilhaft, wenn die akustooptischen Modulatormodule jeweils wenigstens zwei im Strahlengang hintereinander angeordnete akustooptische Modulatoren umfassen, wobei die wenigstens zwei akustooptischen Modulatoren bevorzugt eine im Wesentlichen senkrecht zueinander verlaufende Richtung ihrer Strahlablenkung oder eine gleiche Orientierung ihrer Strahlablenkung aufweisen

Weiters kann die Ablenkeinheit den akustooptischen Modulatormodulen im Strahlengang nachgeordnet sein, insbesondere von einem Galvanometerscanner, gebildet sein, welche(r) ausgebildet ist, um eine gemeinsame Verlagerung der Fokuspunkte in einer quer zur z-Richtung verlaufenden x-y-Ebene zu bewirken.

Insbesondere kann die Bestrahlungseinrichtung ausgebildet sein, um das Bauteil schichtweise mit sich in der x-y-Ebene erstreckenden Schichten aufzubauen, wobei der Wechsel von einer Schicht zu einer nächsten Schicht die Veränderung der Relativposition der optischen Abbildungseinheit relativ zum Bauteil in der z-Richtung umfasst.

Die Bestrahlungseinrichtung ist bevorzugt derart ausgebildet, dass die Feinverstellung des Fokuspunkts in z-Richtung mittels des akustooptischen Modulators innerhalb der Schichtdicke einer Schicht erfolgt.

Weiters kann vorgesehen sein, dass das Material auf einem Materialträger, wie z.B. in einer Wanne, vorliegt, und die Bestrahlung des Materials von unten durch den für die Strahlung zumindest bereichsweise durchlässigen Materialträger erfolgt.

Die Bauplattform wird hierbei bevorzugt in Abstand vom Materialträger positioniert und das wird Bauteil durch Verfestigen von zwischen der Bauplattform und dem Materialträger befindlichen Volumenelementen auf der Bauplattform aufgebaut.

Dabei ist es vorteilhaft, wenn das Volumen des Fokuspunkts während des Aufbaus des Bauteils zumindest einmal variiert wird, sodass das Bauteil aus verfestigten Volumenelementen unterschiedlichen Volumens aufgebaut wird.

Die Abbildungseinheit kann als f-Theta Linse ausgeführt werden oder besteht bevorzugt aus einem Mikroskopieobjektiv und einer Relaysoptik in 4f-Anordnung, wobei die Ablenkeinheit und das Objektiv in der Brennebene der entsprechenden Linsen sitzen.

Die Erfindung wird nachfolgend anhand von in der Zeichnung schematisch dargestellten Ausführungsbeispielen näher erläutert. In dieser zeigen Fig. 1 eine schematische Darstellung einer erfindungsgemäßen Vorrichtung, Fig. 2, 3 und 4 eine Detailansicht von alternativen Ausbildung eines akustooptischen Modulatormoduls und Fig. 5 eine schematische Darstellung der Fokuspunkte im Bildfeld der Vorrichtung bei der Herstellung eines Bauteils.

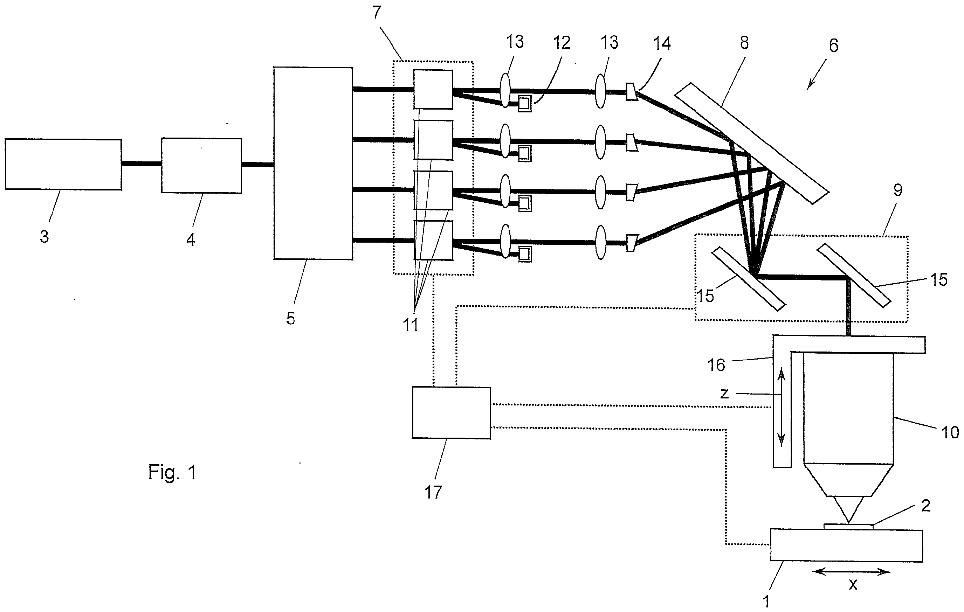

In Fig. 1 ist ein Träger mit 1 bezeichnet, auf welchem ein Bauteil aufgebaut werden soll. Der Träger wird mit einem photopolymerisierbaren Material 2 beschichtet, in welches Laserstrahlen fokussiert werden, wobei jeder Laserstrahl nacheinander auf Fokuspunkte innerhalb des photopolymerisierbaren Materials fokussiert wird, wodurch jeweils ein am Fokuspunkt befindliches Volumenelement des Materials mittels Multiphotonenabsorption verfestigt wird. Zu diesem Zweck wird ein Laserstrahl von einer Strahlungsquelle 3 ausgesendet, durch einen Pulskompressor 4 geleitet und in einem Strahlungsteiler 5 in eine Mehrzahl von Strahlen (im vorliegenden Fall vier Strahlen) aufgeteilt. Die Strahlen werden nun mittels einer Bestrahlungseinrichtung 6 in das Material 2 eingestrahlt. Die Bestrahlungseinrichtung 6 umfasst zu diesem Zweck eine akustooptische Modulatoreinheit 7, einen Umlenkspiegel 8, einen Galvanometerscanner 9 und eine optische Abbildungseinheit 10 umfassend ein Objektiv, welches die Laserstrahlen innerhalb eines Schreibbereichs in das Material 2 einbringt.

Die akustooptische Modulatoreinheit 7 umfasst eine der Anzahl der Strahlen entsprechende Anzahl von akustooptischen Modulatormodulen 11, deren wenigstens einer akustooptischer Modulator den jeweiligen Strahl in einen Strahl nullter Ordnung und einen Strahl erster Ordnung aufteilt. Der Strahl nullter Ordnung wird in einer Strahlfalle 12 aufgefangen. Der Strahl erster Ordnung wird über Relaislinsen 13 und eine Umlenkung 14 auf den Umlenkspiegel 8 gebracht, welcher die Strahlen in die Ablenkeinheit 9 (z.B. ein Galvanometerscanner) führt, in der die Strahlen nacheinander an zwei Spiegeln 15 reflektiert werden. Die Spiegel 15 sind um Drehachsen schwenkbar angetrieben, die zueinander orthogonal verlaufen, sodass die Strahlen sowohl in der x- als auch in der y-Richtung ausgelenkt werden können. Die beiden Spiegel 15 können von je einem Galvanometerantrieb oder Elektromotor angetrieben werden. Die aus der Ablenkeinheit 9 austretenden Strahlen gelangen bevorzugt über ein nicht dargestelltes optionales Relais-Linsensystem in das Objektiv 10, welches die Strahlen wie bereits erwähnt in das photopolymerisierbare Material fokussiert.

Um das Bauteil schichtweise aufzubauen, werden im Material Volumenelemente einer Schicht nach der anderen verfestigt. Zum Aufbau einer ersten Schicht werden die Laserstrahlen jeweils nacheinander auf Fokuspunkte, die in der Fokusebene des Objektivs 10 angeordnet sind, innerhalb des Materials 2 fokussiert. Die gemeinsame Ablenkung der Strahlen in der x,y-Ebene erfolgt hierbei mit Hilfe der Ablenkeinheit 9, wobei der Schreibbereich durch das Objektiv 10 begrenzt ist. Für den Wechsel in die nächste Ebene wird das an einem Träger 16 befestigte Objektiv 10 in z-Richtung relativ zum Träger 1 um den Schichtlagenabstand verstellt, welcher der Schichtdicke entspricht. Alternativ kann auch der Träger 1 relativ zum feststehenden Objektiv 10 verstellt werden.

Wenn das herzustellende Bauteil in x- und/oder y-Richtung größer ist als der Schreibbereich des Objektivs 10, werden Teilstrukturen des Bauteils nebeneinander aufgebaut (sog. Stitching). Dazu ist der Träger 1 auf einem Kreuztisch angeordnet, der in x- und/oder y-Richtung relativ zur Bestrahlungseinrichtung 6 verschiebbar ist.

Weiters ist eine Steuerung 17 vorgesehen, welche die akustooptischen Modulatoreinheit 7, die Ablenkeinheit 9, den Höhenversteller 16 und den am Kreuztisch befestigen Träger 1 ansteuert.

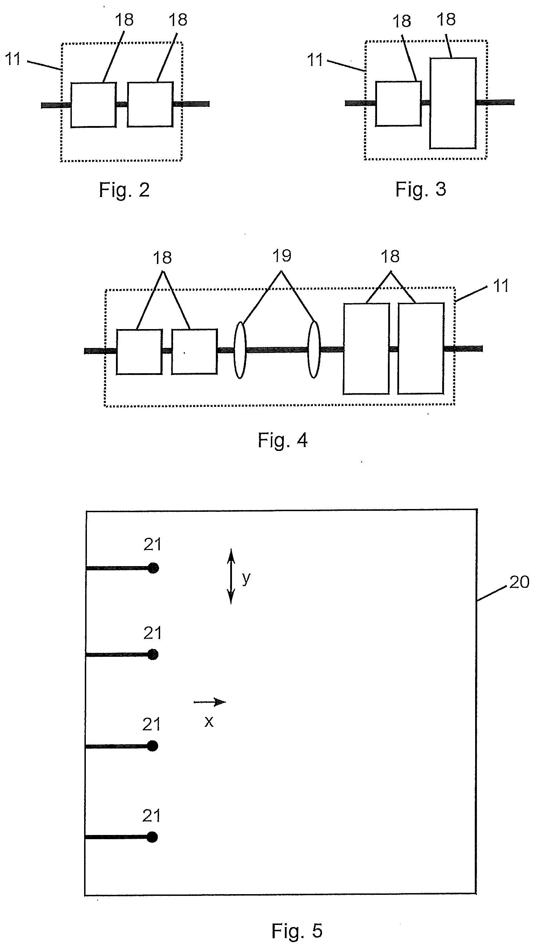

Wie in Fig. 2 dargestellt, kann ein akustooptisches Modulatormodul 11 zwei hintereinander angeordnete akustooptische Modulatoren 18 aufweisen, deren Richtung der Strahlablenkung übereinstimmen. Dies hat den Effekt, dass die Auslenkung doppelt so groß gegenüber einem einzigen akustooptischen Modulator ist, und dass die Auslenkung in x-, y- und z-Richtung unabhängig voneinander angesteuert werden kann. Somit kann jeder beliebige Punkt innerhalb des verfügbaren Auslenkbereichs angesteuert werden und die Feinverstellung des Fokuspunkts in z-Richtung ermöglicht. Nachteilig bei dieser Anordnung ist der auftretende Astigmatismus durch die Zylinderlinse des akustooptischen Modulators.

Die akustooptischen Modulatoren 11 bilden dabei jeweils einen Zylinderlinseneffekt aus, der vom Schallwellenfrequenzgradienten der Frequenzmodulation abhängt. Die äquivalente Brennweite der Zylinderlinse $F_l$ kann hierbei wie folgt berechnet werden:

$$F_l = \frac{v_a{}^2}{\lambda \frac{dF_a}{dt}}$$

wobei $v_a$ die akustische Ausbreitungsgeschwindigkeit im Kristall, $\lambda$ die Wellenlänge des Laserstrahls und $dF_a/dt$ der Schallwellenfrequenzgradient im Kristall darstellt. In TeO$_2$ mit einer Ausbreitungsgeschwindigkeit von 4200 m/s bei einer Wellenlänge des Lasers von 780 nm und dem Durchlaufen einer Bandbreite von $\pm$25 MHz (z.B. ausgehend von einer Grundanregungsfrequenz von 110 MHz) innerhalb von 0,2 us ergibt sich eine Brennweite der akustooptischen Zylinderlinse von 90 mm. Bei einem Objektiv 4 mit einer Brennweite von 9 mm und einer 20x Aufweitung ergibt sich dadurch eine neue Brennweite des Gesamtsystems von

$$F_{total} = \frac{F_{Obj}\, F_l}{F_{Obj} + F_l}$$

was bei den oben erwähnten Parametern eine Verschiebung in z-Richtung, je nach Vorzeichen des Gradienten,

von $\pm 90$ μm. entspricht. Durch Veränderung des Schallwellenfrequenzgradienten kann die z-Position des Volumenelements linear und stufenfrei eingestellt werden.

Bei der alternativen Ausführungsform gemäß Fig. 3 umfasst ein akustooptisches Modulatormodul 11 zwei hintereinander angeordnete akustooptische Modulatoren 18, deren Richtung der Strahlablenkung senkrecht zueinander verläuft. Hinsichtlich des abgelenkten Strahls erster Ordnung wirkt dieses akustooptische Modulatormodul 11 jeweils als Zylinderlinse mit einstellbarer Brennweite, sodass der Strahl erster Ordnung eine einstellbare Divergenz aufweist, mit welcher eine Verstellung des Fokuspunkts in x- und y-Richtung ermöglicht wird, wodurch die Auslenkrichtung des Ablenkeinheit frei gewählt werden kann. Weiters wird durch diese Anordnung der entstehende Astigmatismus minimiert, da zwei zueinander orthogonale Zylinderlinsen erzeugt werden.

In Fig. 4 ist eine abgewandelte Ausführungsform des akustooptischen Modulatormoduls 11 dargestellt, welche ein erstes Paar von akustooptischen Modulatoren 18 und ein zweites Paar von akustooptischen Modulatoren 18 aufweist, zwischen denen Relais-Linsen 19 angeordnet sind, um sicherzustellen, dass der Fokuspunkt am Ein- und am Ausgang des akustooptische Modulatormoduls 11 auf selber Linie angeordnet sind. Die beiden akustooptischen Modulatoren 18 jedes Paars weisen dieselbe Ablenkungsrichtung auf. Das Ablenkungsrichtung der Modulatoren des ersten Paars ist senkrecht zur Ablenkungsrichtung der Modulatoren des zweiten Paars. Dies hat den Effekt, dass die Vorteile der Ausbildung gemäß Fig. 2 und jene der Ausbildung gemäß Fig. 3 kombiniert werden.

In Fig. 5 ist der Schreibbereich bzw. das Bildfeld 20 der optischen Abbildungseinheit 10 in der x- und y-Richtung dargestellt, wobei es sich um jenen Ausschnitt des Bauteils handelt, der ohne Veränderung der Relativposition in x- und y-Richtung zwischen der optischen Abbildungseinheit 10 und dem aufzubauenden Bauteil aufgebaut werden kann. Es sind vier Fokuspunkte 21 ersichtlich, die in einem Abstand voneinander liegen, sodass gleichzeitig vier Volumenelemente des Bauteils unabhängig voneinander hergestellt werden können. Die gemeinsame Fortbewegung der Fokuspunkte 21 in der x-Richtung erfolgt mit Hilfe der Ablenkeinheit 9. Die Fokuspunkte 21 können weiters unabhängig voneinander mittels des jeweiligen akustooptischen Modulatormoduls 11 in x-, y- und/oder z-Richtung ausgehend von ihrer durch die Ablenkeinheit 9 definierten aktuellen Grundposition feinverstellt werden. Beispielsweise kann während der durch die Ablenkeinheit 9 bewirkten Fortbewegung der Fokuspunkte in x-Richtung eine Feinverstellung in z-Richtung vorgenommen werden, um die Position von Volumenelementen ähnlich einer "grayscale lithography" an eine gekrümmte oder relativ zur den Koordinatenrichtungen schräge Bauteilkontur anzupassen. Weiters kann während der durch die Ablenkeinheit 9 bewirkten Fortbewegung der Fokuspunkte in x-Richtung eine Feinverstellung in y-Richtung derart vorgenommen werden, dass der Laserstrahl mit hoher Geschwindigkeit hin- und herbewegt wird, um die Ausdehnung des zu verfestigten Volumenelements in y-Richtung in Abhängigkeit von der Amplitude der Hin- und Herbewegung einstellen zu können.

**Patentansprüche**

1. Verfahren zur lithographiebasierten generativen Fertigung eines dreidimensionalen Bauteils, bei dem ein von einer elektromagnetischen Strahlungsquelle (3) ausgesendeter Strahl mittels einer optischen Abbildungseinheit (10) auf einen Fokuspunkt (21) innerhalb eines Materials (2) fokussiert wird und der Fokuspunkt (21) mittels einer der optischen Abbildungseinheit (10) in Strahlrichtung vorgeordneten Ablenkeinheit (9) verlagert wird, wodurch nacheinander jeweils ein am Fokuspunkt (21) befindliches Volumenelement des Materials (2) mittels Multiphotonenabsorption verfestigt wird, wobei der Strahl mit einem Strahlteiler (4) auf eine Mehrzahl von Strahlen aufgeteilt wird, von denen jeder mittels der Ablenkeinheit (9) und der optischen Abbildungseinheit (10) nacheinander auf Fokuspunkte (21) innerhalb des Materials (2) fokussiert wird, **dadurch gekennzeichnet, dass** eine der Anzahl der Strahlen entsprechende Anzahl von akustooptischen Modulatormodulen (11) vorgesehen wird, sodass im Strahlengang jedes Strahls ein akustooptisches Modulatormodul (11) angeordnet ist, welches den Strahl beugt.

2. Verfahren nach Anspruch 1, **dadurch gekennzeichnet, dass** wenigstens eines der akustooptischen Modulatormodule (11) angesteuert wird, um den Fokuspunkt (21) des zugehörigen Strahls in einer z-Richtung zu verlagern, wobei die z-Richtung einer Einstrahlrichtung des jeweiligen Strahls in das Material (2) entspricht.

3. Verfahren nach Anspruch 1 oder 2, **dadurch gekennzeichnet, dass** wenigstens eines der akustooptischen Modulatormodule (11) angesteuert wird, um den Fokuspunkt des zugehörigen Strahls in einer x- und/oder y-Richtung zu verlagern, wobei die x- und y-Richtung zwei orthogonalen Richtungen in einer zur Einstrahlrichtung des jeweiligen Strahls senkrechten Ebene entsprechen.

4. Verfahren nach Anspruch 1, 2 oder 3, **dadurch gekennzeichnet, dass** in den akustooptischen Modulatormodulen (11) jeweils wenigstens zwei im Strahlengang hintereinander angeordnete akustooptische Modulatoren (18) verwendet werden, wobei die wenigstens zwei akustooptischen Modulatoren (18) bevorzugt eine im Wesentlichen senkrecht zueinander verlaufende Richtung der Strahlablenkung oder eine gleiche Orientierung der Strahlablenkung aufweisen.

5. Verfahren nach einem der Ansprüche 1 bis 4, **dadurch gekennzeichnet, dass** die Strahlen mittels der den akustooptischen Modulatormodulen (11) im Strahlengang nachgeordneten Ablenkeinheit (9), insbesondere einem Galvanometerscanner, einer gemeinsamen Auslenkung in der x- und y-Richtung unterworfen werden.

6. Verfahren nach einem der Ansprüche 1 bis 5, **dadurch gekennzeichnet, dass** das Bauteil schichtweise mit sich in der x-y-Ebene erstreckenden Schichten aufgebaut wird, wobei der Wechsel von einer Schicht zu einer nächsten Schicht die Veränderung der Relativposition der optischen Abbildungseinheit (10) relativ zum Bauteil in der z-Richtung umfasst.

7. Verfahren nach Anspruch 6, **dadurch gekennzeichnet, dass** die Verlagerung des Fokuspunkts (21) in z-Richtung mittels der akustooptischen Modulatormodule (11) innerhalb der Schichtdicke einer Schicht erfolgt.

8. Verfahren nach einem der Ansprüche 1 bis 7, **dadurch gekennzeichnet, dass** zumindest einer der Fokuspunkte (21) mittels der akustooptischen Modulatormodule (11) in z-Richtung verlagert wird, um eine gekrümmte Außenkontur oder eine relativ zur x,y-Ebene schräg verlaufende Außenkontur des Bauteils auszubilden, wobei die Größe der die Außenkontur ausbildenden Volumenelemente bevorzugt gleich gewählt ist.

9. Vorrichtung zur lithographiebasierten generativen Fertigung eines dreidimensionalen Bauteils, insbesondere zur Durchführung eines Verfahrens nach einem der Ansprüche 1 bis 8, umfassend einen Materialträger (1) für ein verfestigbares Material (2) und eine Bestrahlungseinrichtung (6), die zur ortsselektiven Bestrahlung des verfestigbaren Materials mit wenigstens einem Strahl ansteuerbar ist, wobei die Bestrahlungseinrichtung (6) einen Strahlteiler (4) zur Aufteilung eines Eingangsstrahls in mehrere Strahlen, eine dem Strahlteiler (4) im Strahlengang nachgeordnete Ablenkeinheit und eine der Ablenkeinheit (9) nachgeordnete optische Abbildungseinheit (10) umfasst, um jeden Strahl nacheinander auf Fokuspunkte (21) innerhalb des Materials (2) zu fokussieren, wodurch jeweils ein am Fokuspunkt (21) befindliches Volumenelement des Materials (2) mittels Multiphotonenabsorption verfestigbar ist, **dadurch gekennzeichnet, dass** eine der Anzahl der Strahlen entsprechende Anzahl von akustooptischen Modulatormodulen (11) vorgesehen ist, sodass im Strahlengang jedes Strahls ein akustooptisches Modulatormodul (11) angeordnet ist, welches wenigstens einen akustooptischen Modulator (18) umfasst.

10. Vorrichtung nach Anspruch 9, **dadurch gekennzeichnet, dass** die akustooptischen Modulatormodule (11) zur Verlagerung des jeweiligen Fokuspunkts (21) in einer z-Richtung ausgebildet sind, wobei die z-Richtung einer Einstrahlrichtung des zugehörigen Strahls in das Material (2) entspricht.

11. Vorrichtung nach Anspruch 9 oder 10, **dadurch gekennzeichnet, dass** der wenigstens eine akustooptische Modulator (18) einen Frequenzgenerator umfasst, der zur periodischen Modulation der Schallwellenfrequenz ausgebildet ist.

12. Vorrichtung nach Anspruch 11, **dadurch gekennzeichnet, dass** der Frequenzgenerator ausgebildet ist, um den Schallwellenfrequenzgradienten zu verändern.

13. Vorrichtung nach Anspruch 9, 10 oder 11, **dadurch gekennzeichnet, dass** die akustooptischen Modulatormodule (11) zur Verlagerung des jeweiligen Fokuspunkts in einer x- und/oder y-Richtung ausgebildet sind, wobei die x- und y-Richtung zwei orthogonalen Richtungen in einer zur Einstrahlrichtung des jeweiligen Strahls senkrechten Ebene entsprechen.

14. Vorrichtung nach einem der Ansprüche 9 bis 13, **dadurch gekennzeichnet, dass** die akustooptischen Modulatormodule (11) jeweils wenigstens zwei im Strahlengang hintereinander angeordnete akustooptische Modulatoren (18) umfassen, wobei die wenigstens zwei akustooptischen Modulatoren (18) bevorzugt eine im Wesentlichen senkrecht zueinander verlaufende Richtung ihrer Strahlablenkung oder eine gleiche Orientierung ihrer Strahlablenkung aufweisen.

15. Vorrichtung nach einem der Ansprüche 9 bis 14, **dadurch gekennzeichnet, dass** die Ablenkeinheit (9) den akustooptischen Modulatormodulen (11) im Strahlengang nachgeordnet ist, insbesondere von einem Galvanometerscanner gebildet ist, welche(r) ausgebildet ist, um eine gemeinsame Verlagerung der Fokuspunkte (21) in einer quer zur z-Richtung verlaufenden x-y-Ebene zu bewirken.

16. Vorrichtung nach einem der Ansprüche 9 bis 15, **dadurch gekennzeichnet, dass** die Bestrahlungseinrichtung (6) ausgebildet ist, um das Bauteil schichtweise mit sich in der x-y-Ebene erstreckenden Schichten aufzubauen, wobei der Wechsel von einer Schicht zu einer nächsten Schicht die Veränderung der Relativposition der optischen Abbildungseinheit (10) relativ zum Bauteil in der z-Richtung umfasst.

17. Vorrichtung nach einem der Ansprüche 9 bis 16, **da-**

**durch gekennzeichnet, dass** die Bestrahlungsein-richtung (6) derart ausgebildet ist, dass die Verlagerung des Fokuspunkts (21) in z-Richtung mittels des akustooptischen Modulatormoduls (11) innerhalb der Schichtdicke einer Schicht erfolgt.

**Claims**

1. Method for the lithography-based generative production of a three-dimensional component, in which a beam emitted by an electromagnetic radiation source (3) is focused by means of an optical imaging unit (10) onto a focal point (21) within a material (2) and the focal point (21) is displaced by means of a deflection unit (9) arranged upstream of the optical imaging unit (10) in the beam direction, as a result of which a volume element of the material (2) located at the focal point (21) is each successively solidified by means of multiphoton absorption, wherein the beam is divided by a beam splitter (4) into a plurality of beams, each of which is successively focused on focal points (21) within the material (2) by means of the deflection unit (9) and the optical imaging unit (10), **characterized in that** a number of acousto-optic modulator modules (11) corresponding to the number of beams are provided, so that an acousto-optic modulator module (11) which diffracts the beam is arranged in the beam path of each beam.

2. Method according to claim 1, **characterized in that** at least one of the acousto-optic modulator modules (11) is controlled in order to shift the focal point (21) of the associated beam in a z-direction, the z-direction corresponding to a direction of incidence of the respective beam into the material (2).

3. Method according to claim 1 or 2, **characterized in that** at least one of the acousto-optic modulator modules (11) is controlled in order to displace the focal point of the associated beam in an x and/or y direction, the x and y directions corresponding to two orthogonal directions in a plane perpendicular to the direction of incidence of the respective beam.

4. Method according to claim 1, 2 or 3, **characterized in that** at least two acousto-optic modulators (18) arranged one behind the other in the beam path are used in each of the acousto-optic modulator modules (11), the at least two acousto-optic modulators (18) preferably having a direction of beam deflection which is essentially perpendicular to one another or an identical orientation of the beam deflection.

5. Method according to any one of claims 1 to 4, **characterized in that** the beams are subjected to a joint deflection in the x and y directions by means of the deflection unit (9) arranged downstream of the acousto-optical modulator modules (11) in the beam path, in particular a galvanometer scanner.

6. Method according to any one of claims 1 to 5, **characterized in that** the component is built up layer by layer with layers extending in the x-y plane, the change from one layer to a next layer comprising the change in the relative position of the optical imaging unit (10) relative to the component in the z direction.

7. Method according to claim 6, **characterized in that** the focal point (21) is displaced in the z-direction by means of the acousto-optic modulator modules (11) within a layer thickness of a layer.

8. Method according to any one of claims 1 to 7, **characterized in that** at least one of the focal points (21) is displaced in the z-direction by means of the acousto-optic modulator modules (11) in order to form a curved outer contour or an outer contour of the component which runs obliquely relative to the x,y-plane, the size of the volume elements forming the outer contour preferably being selected to be the same.

9. Apparatus for the lithography-based generative production of a three-dimensional component, in particular for carrying out a method according to any one of claims 1 to 8, comprising a material carrier (1) for a solidifiable material (2) and an irradiation device (6) which can be controlled for the position-selective irradiation of the solidifiable material with at least one beam, wherein the irradiation device (6) comprises a beam splitter (4) for splitting an input beam into a plurality of beams, a deflection unit arranged downstream of the beam splitter (4) in the beam path and an optical imaging unit (10) arranged downstream of the deflection unit (9) in order to focus each beam successively on focal points (21) within the material (2), as a result of which a respective volume element of the material (2) located at the focal point (21) can be solidified by means of multiphoton absorption, **characterized in that** a number of acousto-optic modulator modules (11) corresponding to the number of beams is provided, so that an acousto-optic modulator module (11) comprising at least one acousto-optic modulator (18) is arranged in the beam path of each beam.

10. Device according to claim 9, **characterized in that** the acousto-optical modulator modules (11) are designed to displace the respective focal point (21) in a z-direction, the z-direction corresponding to a direction of incidence of the associated beam into the material (2).

11. Device according to claim 9 or 10, **characterized in that** the at least one acousto-optic modulator (18) comprises a frequency generator which is designed for periodic modulation of the sound wave frequency.

12. Device according to claim 11, **characterized in that** the frequency generator is designed to change the sound wave frequency gradient.

13. Device according to claim 9, 10 or 11, **characterized in that** the acousto-optical modulator modules (11) are designed for displacing the respective focal point in an x- and/or y-direction, the x- and y-directions corresponding to two orthogonal directions in a plane perpendicular to the direction of incidence of the respective beam.

14. Device according to any one of claims 9 to 13, **characterized in that** the acousto-optic modulator modules (11) each comprise at least two acousto-optic modulators (18) arranged one behind the other in the beam path, the at least two acousto-optic modulators (18) preferably having a direction of their beam deflection that is essentially perpendicular to one another or an identical orientation of their beam deflection.

15. Device according to any one of claims 9 to 14, **characterized in that** the deflection unit (9) is arranged downstream of the acousto-optical modulator modules (11) in the beam path, in particular is formed by a galvanometer scanner, which is designed to effect a common displacement of the focal points (21) in an x-y plane extending transversely to the z direction.

16. Device according to any one of claims 9 to 15, **characterized in that** the irradiation device (6) is designed to build up the component layer by layer with layers extending in the x-y plane, the change from one layer to a next layer comprising the change in the relative position of the optical imaging unit (10) relative to the component in the z direction.

17. Device according to any one of claims 9 to 16, **characterized in that** the irradiation device (6) is designed in such a way that the displacement of the focal point (21) in the z-direction by means of the acousto-optic modulator module (11) takes place within a layer thickness of a layer.

**Revendications**

1. Procédé de fabrication générative basée sur la lithographie d'une pièce tridimensionnelle, dans lequel un faisceau émis par une source de rayonnement électromagnétique (3) est focalisé par une unité d'imagerie optique (10) sur un point focal (21) à l'intérieur d'un matériau (2) et le point focal (21) est déplacé par une unité de déviation (9) disposée en amont de l'unité d'imagerie optique (10) dans la direction du faisceau, de sorte qu'un élément de volume du matériau (2) situé au point focal (21) est solidifié successivement par absorption multiphotonique, le faisceau étant divisé en plusieurs faisceaux par un diviseur de faisceau (4), chacun de ces faisceaux étant successivement focalisé par l'unité de déviation (9) et l'unité d'imagerie optique (10) sur des points focaux (21) à l'intérieur du matériau (2), **caractérisé en ce qu'**un nombre de modules de modulateur acousto-optique (11) correspondant au nombre de faisceaux est prévu, de sorte qu'un module de modulateur acousto-optique (11) est disposé dans le trajet du faisceau de chaque faisceau, lequel module dévie le faisceau.

2. Procédé selon la revendication 1, **caractérisé en ce qu'**au moins un des modules de modulateur acousto-optique (11) est commandé pour déplacer le point focal (21) du faisceau associé dans une direction z, la direction z correspondant à une direction d'incidence du faisceau respectif dans le matériau (2).

3. Procédé selon la revendication 1 ou 2, **caractérisé en ce qu'**au moins un des modules de modulateur acousto-optique (11) est commandé pour déplacer le point focal du faisceau associé dans une direction x et/ou y, les directions x et y correspondant à deux directions orthogonales dans un plan perpendiculaire à la direction d'incidence du faisceau respectif.

4. Procédé selon la revendication 1, 2 ou 3, **caractérisé en ce que** dans chaque des modules de modulateur acousto-optique (11), au moins deux modulateurs acousto-optiques (18) disposés successivement dans le trajet du faisceau sont utilisés, les au moins deux modulateurs acousto-optiques (18) ayant de préférence des directions de déviation du faisceau qui sont essentiellement perpendiculaires l'une à l'autre, ou bien une même orientation de déviation du faisceau.

5. Procédé selon l'une quelconque des revendications 1 à 4, **caractérisé en ce que** les faisceaux sont soumis à une déviation commune dans les directions x et y au moyen de l'unité de déviation (9) disposée en aval des modules de modulateur acousto-optique (11) dans le trajet du faisceau, en particulier un scanner galvanométrique.

6. Procédé selon l'une quelconque des revendications 1 à 5, **caractérisé en ce que** la pièce est construite couche par couche avec des couches s'étendant dans le plan x-y, le passage d'une couche à la couche suivante comprenant le changement de la position relative de l'unité d'imagerie optique (10) par rapport à la pièce dans la direction z.

7. Procédé selon la revendication 6, **caractérisé en ce que** le déplacement du point focal (21) dans la direction z au moyen des modules de modulateur acousto-optique (11) a lieu à l'intérieur de l'épaisseur de couche d'une couche.

8. Procédé selon l'une quelconque des revendications 1 à 7, **caractérisé en ce qu'**au moins un des points focaux (21) est déplacé dans la direction z au moyen d'un module de modulateur acousto-optique (11) pour former un contour extérieur courbé ou un contour extérieur incliné par rapport au plan x,y de la pièce, la taille des éléments de volume formant le contour extérieur étant de préférence choisie égale.

9. Dispositif pour la fabrication générative basée sur la lithographie d'une pièce tridimensionnelle, en particulier pour la mise en oeuvre d'un procédé selon l'une quelconque des revendications 1 à 8, comprenant un support de matériau (1) pour un matériau (2) pouvant être solidifié et un dispositif d'irradiation (6), qui peut être commandé pour l'irradiation sélective en position du matériau pouvant être solidifié avec au moins un faisceau, le dispositif d'irradiation (6) comprenant un diviseur de faisceau (4) pour diviser un faisceau d'entrée en plusieurs faisceaux, une unité de déviation disposée en aval du diviseur de faisceau (4) dans le trajet du faisceau et une unité d'imagerie optique (10) disposée en aval de l'unité de déviation (9) pour focaliser successivement chaque faisceau sur des points focaux (21) à l'intérieur du matériau (2), de sorte qu'un élément de volume du matériau (2) situé au point focal (21) peut être solidifié par absorption multiphotonique, **caractérisé en ce qu'un** nombre de modules de modulateur acousto-optique (11) correspondant au nombre de faisceaux est prévu, de sorte qu'un module de modulateur acousto-optique (11) est disposé dans le trajet du faisceau de chaque faisceau, lequel module comprend au moins un modulateur acousto-optique (18).

10. Dispositif selon la revendication 9, **caractérisé en ce que** les modules de modulateur acousto-optique (11) sont conçus pour déplacer le point focal respectif (21) dans une direction z, la direction z correspondant à une direction d'incidence du faisceau associé dans le matériau (2).

11. Dispositif selon la revendication 9 ou 10, **caractérisé en ce que** l'au moins un modulateur acousto-optique (18) comprend un générateur de fréquence, qui est conçu pour la modulation périodique de la fréquence des ondes sonores.

12. Dispositif selon la revendication 11, **caractérisé en ce que** le générateur de fréquence est conçu pour modifier le gradient de fréquence des ondes sonores.

13. Dispositif selon la revendication 9, 10 ou 11, **caractérisé en ce que** les modules de modulateur acousto-optique (11) sont conçus pour déplacer le point focal respectif dans une direction x et/ou y, les directions x et y correspondant à deux directions orthogonales dans un plan perpendiculaire à la direction d'incidence du faisceau respectif.

14. Dispositif selon l'une quelconque des revendications 9 à 13, **caractérisé en ce que** les modules de modulateur acousto-optique (11) comprennent chacun au moins deux modulateurs acousto-optiques (18) disposés successivement dans le trajet du faisceau, les au moins deux modulateurs acousto-optiques (18) ayant de préférence des directions de déviation du faisceau qui sont essentiellement perpendiculaires l'une à l'autre, ou bien une même orientation de déviation du faisceau.

15. Dispositif selon l'une quelconque des revendications 9 à 14, **caractérisé en ce que** l'unité de déviation (9) est disposée en aval des modules de modulateur acousto-optique (11) dans le trajet du faisceau, et est en particulier formée par un scanner galvanométrique, qui est conçu pour effectuer un déplacement commun des points focaux (21) dans un plan x-y s'étendant transversalement à la direction z.

16. Dispositif selon l'une quelconque des revendications 9 à 15, **caractérisé en ce que** le dispositif d'irradiation (6) est conçu pour construire la pièce couche par couche avec des couches s'étendant dans le plan x-y, le passage d'une couche à la couche suivante comprenant le changement de la position relative de l'unité d'imagerie optique (10) par rapport à la pièce dans la direction z.

17. Dispositif selon l'une quelconque des revendications 9 à 16, **caractérisé en ce que** le dispositif d'irradiation (6) est conçu de telle sorte que le déplacement du point focal (21) dans la direction z au moyen du module de modulateur acousto-optique (11) a lieu à l'intérieur de l'épaisseur de couche d'une couche.

Fig. 1

Fig. 2

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10111422 A1
- WO 2015197794 A1
- WO 2018006108 A1

**In der Beschreibung aufgeführte Nicht-Patentliteratur**

- **ZIPFEL et al.** Nonlinear magic: multiphoton microscopy in the biosciences. *NATURE BIOTECHNOLO-GY,* November 2003, vol. 21 (11